# FASCICULE DE BREVET EUROPEEN

(11) **EP 2 545 209 B1**
(45) Date de publication et mention de la délivrance du brevet: **22.04.2015**
(21) Numéro de dépôt: 11713307.4
(22) Date de dépôt: 17.02.2011
(51) Int. Cl.: C25D 3/56, C25D 3/58, C25D 9/08, H01L 31/0216, H01L 31/032, H01L 31/0336, H01L 31/18, C25D 9/06, C25D 11/00

(54) **PROCEDE DE PREPARATION D'UNE COUCHE MINCE D'ABSORBEUR POUR CELLULES PHOTOVOLTAÏQUES**
VERFAHREN ZUR VORBEREITUNG EINER DÜNNEN ABSORPTIONSSCHICHT FÜR PHOTOVOLTAISCHE ZELLEN
PROCESS FOR THE PREPARATION OF A THIN ABSORBER LAYER FOR PHOTOVOLTAIC CELLS

(30) Priorité: 11.03.2010 FR 1051769
(43) Date de publication de la demande: 16.01.2013
(73) Titulaire: Electricité de France, 75008 Paris (FR); Centre National de la Recherche Scientifique (CNRS), 75794 Paris Cedex 16 (FR)
(72) Inventeur: CHASSAING, Elisabeth, F-91550 Paray-Vieille-Poste (FR); LINCOT, Daniel, F-92160 Antony (FR)
(74) Mandataire: Cabinet Plasseraud
(86) Numéro de dépôt international: PCT/FR2011/050345
(87) Numéro de publication internationale: WO 2011/110763

(56) Documents cités:
- EP-A1- 0 574 716
- WO-A1-2004/061924
- WO-A1-2007/041650
- DE-A1- 19 630 321
- GB-A- 2 370 282
- US-A- 4 581 108
- US-A- 5 804 054
- YUKAWA T ET AL: "ELECTRODEPOSITION OF CUINS2 FROM AQUEOUS SOLUTION (II) ELECTRODEPOSITION OF CUINS2 FILM", THIN SOLID FILMS, ELSEVIER-SEQUOIA S.A. LAUSANNE, CH LNKD- DOI:10.1016/S0040-6090(96)08545-8, vol. 286, no. 1/02, 30 septembre 1996 (1996-09-30), pages 151-153, XP000690723, ISSN: 0040-6090

## Description

La présente invention concerne la fabrication de cellules photovoltaïques, notamment pour la conversion de l'énergie solaire en énergie électrique. Plus particulièrement, la présente invention se rapporte à un procédé de préparation d'une couche mince d'absorbeur pour cellules photovoltaïques et à un procédé de fabrication d'une cellule solaire comprenant une couche mince d'absorbeur préparée selon l'invention.

Les cellules photovoltaïques présentent souvent une structure selon un empilement de couches minces dont l'une au moins de ces couches minces possède des propriétés photovoltaïques.

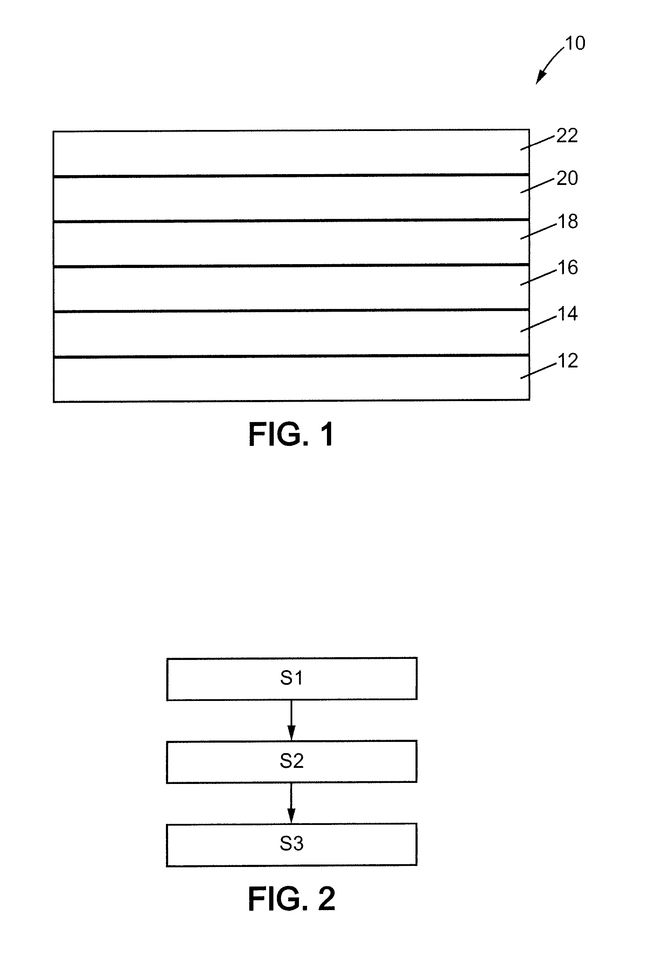

Un exemple de structure de cellules photovoltaïques est représenté sur la figure 1.

Comme représenté sur la figure 1, une cellule photovoltaïque présente généralement un empilement de couches disposées sur un support isolant 12. Généralement, le support isolant 12 est une couche de verre.

Sur le support isolant 12 est déposée une couche de molybdène 14 d'une épaisseur comprise entre 0,5 µm et 1 µm. La couche de molybdène 14 est généralement déposée par évaporation sous vide ou pulvérisation.

Une couche d'absorbeur 16 est déposée sur la couche de molybdène 14. La couche d'absorbeur 16 présente généralement une épaisseur d'environ 2 microns et peut être déposée par évaporation sous vide ou pulvérisation cathodique.

Une couche interfaciale 18 est déposée sur la couche d'absorbeur 16. La couche interfaciale 18 aussi appelée couche tampon, peut comprendre du sulfure de cadmium ou du sulfure de zinc déposé par voie chimique en solution. La couche interfaciale 18 présente une épaisseur comprise généralement entre 10 nm et 80 nm.

Une couche d'oxyde de zinc faiblement dopée 20 est déposée par pulvérisation cathodique sur la couche interfaciale 18. La couche d'oxyde de zinc faiblement dopée 20 présente une épaisseur d'environ 50 nm à 100 nm.

Une couche d'oxyde de zinc dopée à l'aluminium 22 est déposée sur la couche d'oxyde de zinc faiblement dopée 20. La couche d'oxyde de zinc dopée à l'aluminium 22 est classiquement déposée par pulvérisation sous vide de manière à présenter une épaisseur d'environ 0,5 µm à 1 µm.

Le dopage de cette couche d'oxyde de zinc a pour but de rendre cette couche conductrice de type n et de servir d'électrode, (transparente dans le visible) en face avant de la cellule photovoltaïque.

Des cellules photovoltaïques dont la couche d'absorbeur 16 est constituée de composés de type CuInSe₂ ou Cu(Inₓ,Ga₁₋ₓ)Se₂, présentent des rendements de conversion pouvant aller jusqu'à 20 %.

La principale méthode de préparation de cellules photovoltaïques en couches minces fait appel à des voies physiques, par exemple co-évaporation ou encore pulvérisation cathodique.

Les propriétés photovoltaïques des couches minces de type CuInSe₂ ou Cu(Inₓ, Ga₁₋ₓ)Se₂ dépendent grandement de la composition de la couche mince d'absorbeur. Ainsi, il est important de pouvoir contrôler le plus précisément possible la composition de la couche mince d'absorbeur.

Le document EP 0 574 716 A1 propose un procédé de préparation d'une couche mince d'absorbeur pour cellules photovoltaïques de type A-B-C₂ ou A₂-(Dₓ,E₁₋ₓ)-C₄ comprenant des étapes de dépôt d'oxydes des éléments A ou B par ablation laser sur un substrat molybdène, et de recuit sous atmosphère réductrice comprenant un élément du groupe 16, à une température comprise entre 400°C et 600°C.

Le document GB 2 370 282 propose un procédé de préparation d'une couche mince d'absorbeur pour cellules photovoltaïques de type CIS ou CIGS comprenant les étapes d'électroplacage des éléments Cu, In et/ou Ga non oxydés sur un substrat en molybdène, de sélénisation ou bien sulphurisation, puis de recuit.

Le document XP000690723 est un article décrivant un procédé de préparation d'une couche mince d'absorbeur pour cellules photovoltaïques de type CIS comprenant une étape d'électroplacage de tous les éléments de la couche, suivi d'un recuit sous vide à 400°C.

Le document DE 196 30 321 décrit un procédé de préparation d'une couche mince d'absorbeur pour cellules photovoltaïques de type CIS comprenant les étapes d'électroplacage de tous les éléments de la couche suivi d'un recuit à une température comprise entre 100°C et 550°C.

Le dépôt par voie électrochimique est un procédé qui peut permettre d'améliorer le contrôle de la composition des couches minces de type CuInSe₂ ou Cu (Inₓ, Ga₁₋ₓ) Se₂.

Un procédé de dépôt d'un alliage de CuInSe₂ par voie électrochimique est décrit dans la demande US 4,581,108.

Le procédé décrit dans la demande US 4,581,108 comprend les étapes successives suivantes :
- dépôt électrochimique d'une couche mince de cuivre (Cu) et d'Indium (In),
- apport de Sélénium (Se) par sélénisation de sorte à former une couche de CuInSe₂.

La réalisation d'une couche mince d'absorbeur par dépôt électrochimique est complexe à mettre en oeuvre entre autre en raison de :
- la très grande différence de potentiels d'oxydoréduction des différents éléments constituant la couche mince,
- la faible solubilité des sels d'indium et/ou de gallium,
- la forte affinité du gallium pour l'oxygène, et
- la grande complexité de la chimie du sélénium.

Il existe donc un besoin d'un procédé facile à mettre en oeuvre et permettant de réaliser des couches d'absorbeur dont la composition est bien contrôlée.

L'invention propose ainsi, un procédé de préparation d'une couche mince d'absorbeur pour cellules photovoltaïques de type A-B-C₂ ou A₂-(Dₓ,E₁₋ₓ)-C₄ avec 0≤x≤1, A est un élément ou un mélange d'éléments choisis dans le groupe 11, B est un élément ou un mélange d'éléments choisis dans le groupe 13, C est un élément ou un mélange d'éléments choisis dans le groupe 16, D est un élément ou un mélange d'éléments choisis dans le groupe 12 et E est un élément ou un mélange d'éléments choisis dans le groupe 14, ledit procédé comprenant les étapes successives suivantes :
- une première étape de dépôt électrochimique d'une couche mince d'un mélange d'oxydes et/ou d'hydroxydes comprenant pour une couche de type A-B-C₂ au moins un élément du groupe 11 et un élément du groupe 13 ou pour une couche de type A₂-(Dₓ,E₁₋ₓ)-C₄ au moins un élément du groupe 11, au moins un élément du groupe 12 si x>0, et au moins un élément du groupe 14 si x<1,
- une seconde étape de recuit sous atmosphère réductrice de la couche mince,
- une troisième étape d' apport d'au moins un élément du groupe 16 de manière à former une couche mince de type A-B-C₂ ou A₂-(Dₓ,E₁₋ₓ)-C₄ avec 0≤x≤1.

Avantageusement, le dépôt électrochimique des éléments des groupes 11, 12, 13, et 14 sous forme d'oxyde et/ou d'hydroxydes est plus facile à réaliser et permet un meilleur contrôle de la composition finale que le dépôt électrochimique de ces éléments sous forme non-oxydée. En particulier, la solution d'électrolyte est plus stable lorsque l'on veut former les oxydes en absence d'éléments Se ou S en solution et contrairement au dépôt électrochimique de l'art antérieur, la composition chimique de la couche mince d'absorbeur n'évolue pas au cours de la croissance de ladite couche.

Avantageusement, il est possible de déposer sur de grandes surfaces par une technique de revêtement parfaitement établie sur un plan industriel et de grand intérêt pour la production de panneaux photovoltaïques à grandes échelles et à bas coût.

Un procédé selon l'invention peut en outre comporter une ou plusieurs des caractéristiques optionnelles ci-dessous, considérées individuellement ou selon toutes les combinaisons possibles :
- le dépôt électrochimique est réalisé à une température supérieure ou égale à 5°C et inférieure ou égale à 95°C ;
- le recuit sous atmosphère réductrice est réalisé à une température supérieure ou égale à 300°C et inférieure ou égale à 650°C ;
- le recuit sous atmosphère réductrice a une durée supérieure ou égale à 20 secondes et inférieure ou égale à 15 minutes ;
- préalablement au dépôt électrochimique de la couche mince, on prépare une solution aqueuse contenant un mélange de sels de A et de B pour une couche de type A-B-C₂ ou un mélange de sel de A, D et/ou E pour une couche de type A₂-(Dₓ,E₁₋ₓ)-C₄, en présence d'au moins une espèce donneuse d'oxygène ;
- l'espèce donneuse d'oxygène est constituée par un ion nitrate, ou du dioxygène, ou du peroxyde d'hydrogène ou des ions hypochlorites ;
- l'élément A est du cuivre ou de l'argent ou un mélange de cuivre et d'argent et C est du sélénium ou du soufre ou un mélange de sélénium et de soufre ;
- la couche mince d'absorbeur pour cellules photovoltaïques est de type A-B-C₂ et B comprenant un ou plusieurs éléments choisis parmi l'indium, le gallium, l'aluminium ou l'un de leurs mélanges ;
- le dépôt électrochimique est réalisé en imposant un potentiel supérieur ou égal à -1,8 V, par exemple supérieur ou égal à -1,0 V, et inférieur ou égal à -0,5V, par exemple inférieur ou égal à -0,70 V, par rapport à une électrode de référence Hg/Hg₂SO₄/K₂SO₄ saturée à une électrode comprenant un substrat isolant recouvert d'une couche de molybdène ou une densité de courant comprise entre 1 et 30 mAcm⁻² ;
- le dépôt électrochimique est réalisé en imposant un potentiel
   - supérieur ou égal à -1,8 V et strictement inférieur à -1,0 V, ou
   - supérieur ou égale à -1,0 V et inférieur ou égal à -0,70 V, ou
   - strictement supérieur à -0,70 V et inférieur ou égal à -0,5V,
   par rapport à une électrode de référence Hg/Hg₂SO₄/K₂SO₄ saturée à une électrode comprenant un substrat isolant recouvert d'une couche de molybdène ou une densité de courant comprise entre 1 et 30 mAcm² ;
- le rapport atomique des éléments A et B dans la solution d'électrolyte est supérieur ou égal à 0,2, par exemple supérieur ou égal à 0,8 et inférieur ou égal à 1,5, par exemple inférieur ou égal à 1,2 ;
- le rapport atomique des éléments A et B dans la solution d'électrolyte est :
   - supérieur ou égal à 0,2 et strictement inférieur à 0,8, ou
   - supérieur ou égal à 0,8 et inférieur ou égal à 1,2, ou
   - strictement supérieur à 1,2 et inférieur ou égal à 1,5 ;
- la couche mince d'absorbeur pour cellules photovoltaïques est de type A-B-C₂ et B comprenant un mélange d'indium et de gallium, et dans lequel le rapport des concentrations en indium et en gallium dans la solution d'électrolyte est supérieur ou égal à 0,2, par exemple supérieur ou égal à 0,8, et inférieur ou égal à 1,5, par exemple inférieur ou égal à 1,2 ; et
- la couche mince d'absorbeur pour cellules photovoltaïques est de type A-B-C₂ et B comprenant un mélange d'indium et de gallium, et dans lequel le rapport des concentrations en indium et en gallium dans la solution d'électrolyte est :
   - supérieur ou égal à 0,2 et strictement inférieur à 0,8, ou
   - supérieur ou égal à 0,8 et inférieur ou égal à 1,2, ou
   - strictement supérieur à 1,2 et inférieur ou égal à 1,5.

L'invention se rapporte également à un procédé de fabrication d'une cellule solaire, comportant un procédé de préparation d'une couche mince d'absorbeur pour cellules photovoltaïques selon l'invention.

L'invention sera mieux comprise à la lecture de la description qui va suivre, donnée uniquement à titre d'exemple et faite en se référant aux dessins annexés dans lesquels :
- la figure 1 représente schématiquement un empilement de couches minces formant une cellule photovoltaïque,
- la figure 2 représente les différentes étapes d'un procédé selon l'invention,
- la figure 3 est un graphique illustrant l'influence de la teneur en gallium dans la couche mince d'absorbeur sur le rendement de conversion d'une cellule photovoltaïque comprenant une telle couche mince d'absorbeur,
- la figure 4 est un graphique illustrant l'influence de la durée du recuit sous atmosphère réductrice de la couche mince de l'absorbeur sur le rendement de conversion d'une cellule photovoltaïque comprenant une telle couche mince d'absorbeur,
- la figure 5 est un graphique illustrant l'influence de la température du recuit sous atmosphère réductrice d'une couche mince d'absorbeur sur le rendement de conversion d'une cellule photovoltaïque comprenant une telle couche mince d'absorbeur,
- la figure 6 est un diagramme de diffraction des rayons X d'une couche mince d'absorbeur après recuit en atmosphère réductrice,
- les figures 7 et 8 représentent des profils de température du recuit en atmosphère réductrice et du recuit sous vapeur de sélénium d'un exemple de réalisation de l'invention.

Pour des raisons de clarté, les différents éléments représentés sur les figures ne sont pas nécessairement à l'échelle.

L'invention se rapporte à un procédé de préparation d'une couche mince d'absorbeur pour cellules photovoltaïques. La couche mince d'absorbeur étant à base d'un alliage de type A-B-C₂ ou A₂-(Dₓ, E₁₋ₓ)-C₄ avec 0≤x≤1 et A est un élément ou un mélange d'éléments choisis dans le groupe 11, B est un élément ou un élément choisi dans le groupe 13, C est un élément ou un mélange d'éléments choisis dans le groupe 16, D est un élément ou un mélange d'éléments choisis dans le groupe 12 et E est un élément ou mélange d'éléments choisis dans le groupe 14.

Selon un mode de réalisation de l'invention, A est un élément ou un mélange d'éléments choisis parmi le cuivre (Cu) et l'argent (Ag).

Selon un mode de réalisation de l'invention, B est un élément ou un mélange d'éléments choisis parmi l'aluminium (Al), le gallium (Ga), et l'indium (In).

Selon un mode de réalisation de l'invention, C est un élément ou un mélange d'éléments choisis parmi le soufre (S) et le sélénium (Se).

Selon un mode de réalisation de l'invention, D est un élément ou un mélange d'éléments choisis parmi le zinc (Zn) et le cadmium (Cd).

Selon un mode de réalisation de l'invention, E est un élément ou un mélange d'éléments choisis parmi le silicium (Si), le germanium (Ge), l'étain (Sn) et le plomb (Pb).

Selon un mode de réalisation de l'invention, la couche mince d'absorbeur est à base d'un alliage de type CuₚAg₁₋ₚ(InₓGa_{y}Al_{z})Se₂ avec 0≤p≤1, 0≤x≤1, 0≤y≤1, 0≤z≤1 et x+y+z = 1.

Selon un mode de réalisation de l'invention, la couche mince d'absorbeur est à base d'un alliage de type Cu(InₓGa₁₋ₓ)Se₂ avec 0≤x≤1.

Selon un mode de réalisation de l'invention, la couche mince d'absorbeur est à base d'un alliage de type Cu₂(SnₓZn₁₋ₓ) (Se_{y}S_{1-y})₄ avec 0≤x≤1 et 0≤y≤1.

Comme représenté sur la figure 2, un procédé selon l'invention comprend :
- une étape de dépôt électrochimique S1,
- une étape de recuit sous atmosphère réductrice S2, et
- une étape d'apport S3 d'au moins un élément du groupe 16.

Selon un mode de réalisation de l'invention préalablement à l'étape de dépôt électrochimique S1, le procédé comprend une étape de préparation d'un électrolyte.

Avantageusement, le procédé selon l'invention utilise le dépôt de couche d'oxyde d'éléments A, B, D, ou E. Ce dépôt de la couche d'oxydes et/ou d'hydroxydes peut s'effectuer par électrolyse à basse température, supérieure ou égale à 5°C et inférieure ou égale à 95°C, et ne nécessite pas d'appareillage couteux de dépôt sous vide ou en phase vapeur.

L'électrolyte peut, par exemple, être une solution aqueuse contenant un mélange de sels de A et de B en vue de préparer un suivi de la préparation d'une couche de type A-B-C₂ ou un mélange de sels de A, D et/ou E pour une couche de type A₂-(DₓE₁₋ₓ)-C₄. Les sels sont mélangés en présence d'une espèce donneuse d'oxygène. Selon un mode de réalisation, les sels des éléments A, B, D et E peuvent être des nitrates. L'espèce donneuse d'oxygène peut être un nitrate, ou encore de l'oxygène gazeux ou du peroxyde d'hydrogène ou des ions hypochlorites.

La solution aqueuse peut comprendre également un électrolyte support afin d'augmenter sa conductivité.

Avantageusement, les solutions aqueuses électrolytes selon l'invention sont stables et ne présentent aucune tendance à la précipitation.

Le dépôt électrochimique peut se faire en appliquant à une électrode de dépôt un potentiel par rapport à une électrode de référence ou une densité de courant. L'électrode de dépôt peut comprendre une plaque d'isolant, par exemple une plaque en verre recouverte d'une couche de molybdène. L'électrode de référence peut être une électrode au calomel saturée ou une électrode au sulfate mercureux ou encore une électrode Ag/AgCl.

Selon un mode de réalisation, le dépôt électrochimique est réalisé à une température supérieure ou égale à 5°C et inférieure ou égale à 95°C, par exemple à une température supérieure ou égale à 30°C, de préférence supérieure ou égale à 60°C et inférieure ou égale à 83°C, par exemple sensiblement égale à 80°C.

Selon le mode de réalisation l'élément A est du cuivre et l'élément B est choisi parmi l'indium, le gallium et l'aluminium ou l'un de leurs mélanges, le dépôt électrochimique est réalisé en imposant à l'électrode un potentiel par rapport à une électrode de référence au sulfate mercureux saturée supérieur ou égal à -1,8 V, par exemple supérieur ou égal à -1V, et inférieur ou égal à -0,5V, par exemple inférieur ou égal à -0,70 V. On peut également imposer une densité de courant comprise entre 1,0 et 30 mAcm⁻².

La couche d'oxyde et/ou d'hydroxyde est déposée sur l'électrode comprenant un substrat isolant recouvert d'une couche de molybdène sous forme d'une couche mince dont l'épaisseur est contrôlée par la quantité d'électricité échangée pendant la réaction, la température de réaction et la durée de réaction.

Les vitesses de dépôt sont élevées environ 3,5 micromètres par heure à 25°C et plus de 10 micromètres par heure à 80°C.

Typiquement, le dépôt est effectué en solution aqueuse pendant une durée d'environ 10 à 20 minutes et conduit à la formation d'une couche d'oxyde d'épaisseur comprise entre 600 et 2 000 nanomètres, par exemple entre 800 et 1 200 nanomètres.

La composition de la couche d'absorbeur déposée est maîtrisée d'une part par la composition en sels de la solution aqueuse et par le potentiel ou la densité de courant imposé à l'électrode de dépôt.

Les inventeurs ont pu remarquer que les cellules photovoltaïques obtenues avec des couches d'absorbeurs comprenant des alliages de types A-B-C₂ présentent des rendements de conversion améliorés lorsque le rapport atomique des éléments A et B dans la solution d'électrolyte est supérieur ou égal à 0,2, par exemple supérieur à 0,8, et inférieur ou égal à 1,5, par exemple inférieur ou égal à 1,2, par exemple inférieur ou égal à 1, par exemple sensiblement égal à 1.

Par exemple, dans le cas d'absorbeur comprenant un alliage de type Cu(InₓGa₁₋ₓ)Se₂, les inventeurs ont observé que le rendement de conversion est amélioré lorsque le rapport atomique Cu/(In+Ga) est proche de l'unité et la teneur en gallium : Ga/(In+Ga) est supérieure ou égale à 0,2 et inférieure ou égale à 0,35, par exemple, sensiblement égale à 0,3.

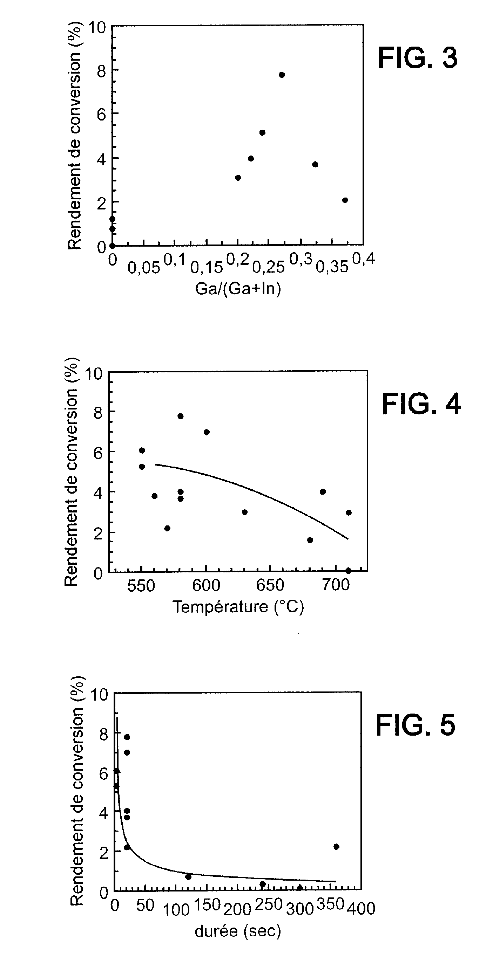

La figure 3 illustre l'influence de la teneur en gallium dans la couche d'absorbeur de type Cu(InₓGa₁₋ₓ)S₂ sur le rendement de conversion de la cellule photovoltaïque comprenant ladite couche d'absorbeur.

Il apparaît que le rendement de conversion est optimal pour une teneur en gallium Ga/(In+Ga) comprise entre 0,2 et 0,35 de préférence sensiblement égal à 0,3. Les inventeurs ont pu observer par diffraction des rayons X que les dépôts des oxydes et/ou hydroxydes présentent un aspect amorphe.

Le procédé selon l'invention comprend en outre une étape de recuit sous atmosphère réductrice de la couche mince d'oxyde obtenue lors du dépôt électrochimique.

La figure 4 illustre l'influence de la température de l'étape de recuit sous atmosphère réductrice sur le rendement de conversion d'une cellule photovoltaïque comprenant une couche d'absorbeur de type Cu(InₓGa₁₋ₓ)S₂, l'étape de recuit étant réalisée sous atmosphère d'éthanol pendant 20 secondes.

Comme illustré sur la figure 4, il est avantageux afin d'augmenter le rendement de conversion que l'étape de recuit sous atmosphère réductrice soit réalisée à une température supérieure ou égale à 300°C et inférieure ou égale à 650°C, par exemple à une température supérieure ou égale à 500°C et inférieure ou égale à 575°C, par exemple à une température sensiblement égale à 550°C.

Selon un mode de réalisation de l'invention, l'étape de recuit sous atmosphère réductrice peut durer entre 20 secondes et 15 minutes, par exemple entre 20 secondes et 5 minutes.

La figure 5 illustre l'influence de la durée de l'étape de recuit sous atmosphère réductrice sur le rendement de conversion d'une cellule photovoltaïque comprenant une couche d'absorbeur de type Cu(InₓGa₁₋ₓ)S₂, l'étape de recuit étant réalisée sous atmosphère d'éthanol à une température de 550°C.

Comme illustré sur la figure 5, il est avantageux afin d'augmenter le rendement de conversion que l'étape de recuit sous atmosphère réductrice dure entre 20 secondes et 50 secondes.

L'étape de recuit sous atmosphère réductrice peut se faire en utilisant un mélange H₂/N₂ ou des vapeurs d'alcool, d'hydrocarbures ou encore des vapeurs d'ammoniaque.

L'étape de recuit sous atmosphère réductrice permet une réduction de la couche d'oxyde en alliage métallique.

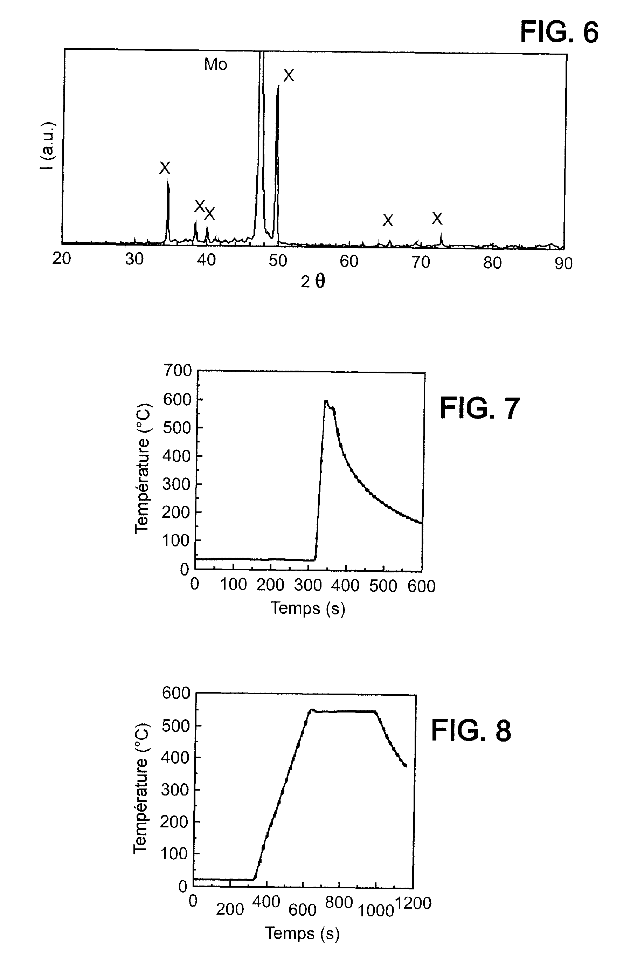

La figure 6 est un diagramme de diffraction des rayons X d'un dépôt de mélange d'oxyde de cuivre, gallium et indium après l'étape de recuit sous atmosphère réductrice. Le diagramme de diffraction représenté à la figure 6 permet de distinguer une phase cubique de type Cu₉In₄ et Cu₉Ga₄ ainsi qu'un grand pic correspondant au substrat de molybdène. Le diagramme peut être indexé comme une phase mixte Cu₉(Inₓ, Ga₁₋ₓ)₄ de structure cubique et un paramètre intermédiaire entre celui de Cu₉In₄ et de Cu₉Ga₄.

Comme il apparaît sur le diagramme de la figure 6 à l'issue de l'étape de recuit sous atmosphère réductrice, l'ensemble des oxydes ont été réduits.

Le procédé selon l'invention comprend en outre une étape d'ajout d'au moins un élément du groupe 16 de manière à former une couche mince de type A-B-C₂ ou A₂-(Dₓ, E₁₋ₓ)-C₄ avec 0≤x≤1. Par exemple, l'étape d'ajout peut être une étape classique de sélénisation qui conduit à la formation d'un composé de type CIS ou CIGS.

L'invention se rapporte également à un procédé de fabrication d'une cellule solaire comprenant la préparation d'une couche mince d'absorbeur selon l'invention et les étapes de compléter les cellules par une couche tampon de CdS par exemple par CBD (« Chemical Bath Deposition ») et le dépôt de la couche finale TCO (« Oxyde Transparent Conducteur »).

Les cellules solaires peuvent ensuite être caractérisées de façon classique.

### Exemple de préparation d'une cellule photovoltaïque comprenant une couche d'absorbeur de type Cu(InₓGa₁₋ₓ)Se₂.

Une solution de nitrate de cuivre à 15x10⁻³ mol.l⁻¹, de nitrate d'indium à 8x10⁻³ mol.l⁻¹ et de nitrate de gallium à 8x10⁻³ mol.l⁻¹ et mélangée à un électrolyte support de nitrate de sodium à 0,1 mol.l⁻¹ à un pH de 1,86. La température de la solution est fixée à 80°C.

Une électrode de dépôt constituée d'une plaque de verre recouverte d'une couche de molybdène de 500 nm d'épaisseur est utilisée.

Une électrolyse est réalisée à une différence de potentiel de -0,825 V entre l'électrode de dépôt et une électrode au sulfate mercureux saturée (Hg/Hg₂SO₄ / K₂SO₄ saturé) pendant 8 minutes environ. La composition de la couche d'oxyde analysée par fluorescence des rayons X est de 44 % atomique de cuivre, 38 % atomique d'indium et 18 % atomique de gallium, le rapport gallium/(indium+gallium) est donc de 0,32 et le rapport cuivre/(indium+gallium) est de 0,8. L'épaisseur de la couche d'oxyde est d'environ 1 micromètre.

Un recuit rapide sous vapeur d'éthanol dans un four à lampe est effectué pendant environ 20 secondes à 580°C selon le profil de température représenté à la figure 7.

Après ce recuit sous atmosphère réductrice, on obtient un film d'alliage Cu-In-Ga de structure proche de Cu₉(In,Ga)₄ comme le confirme le diagramme de diffraction représenté à la figure 6.

Le traitement réducteur est suivi d'un recuit plus long sous pression de vapeur de sélénium selon de profil de température représenté à la figure 8.

Après ce deuxième traitement thermique sous vapeur de sélénium, l'épaisseur de la couche est d'environ 2,8 micromètres, le film contient environ 21 % atomique de cuivre, 54 % atomique de sélénium, 19 % atomique d'indium et 7 % atomique de gallium soit un rapport (sélénium/cuivre+indium+gallium) d'environ 1,2.La couche subit ensuite un traitement classique de décapage en milieu cyanuré suivi du dépôt d'une couche de CdS par dépôt chimique.

Une double couche finale d'oxyde de zinc faiblement dopée suivie d'une couche d'oxyde de zinc dopée à l'aluminium est déposée par pulvérisation cathodique.

Le rendement de conversion de la cellule solaire obtenue est mesuré au simulateur solaire en condition standard (AM 1,5).

Le rendement de conversion est d'environ 7,8 % sur une surface de 0,1 cm², la tension de circuit ouvert est d'environ 0,375 V, la densité de courant de circuit ouvert est d'environ 35 mA.cm⁻² et le facteur de forme d'environ 60 %. L'invention ne se limite pas aux modes de réalisations décrits et doit être interprétée de façon non limitative, et englobant tout mode de réalisation équivalent.

## Revendications

1. Procédé de préparation d'une couche mince d'absorbeur pour cellules photovoltaïques de type A-B-C₂ ou A₂-(Dₓ,E₁₋ₓ)-C₄ avec 0≤x≤1, A est un élément ou un mélange d'éléments choisis dans le groupe 11, B est un élément ou un mélange d'éléments choisis dans le groupe 13, C est un élément ou un mélange d'éléments choisis dans le groupe 16, D est un élément ou un mélange d'éléments choisis dans le groupe 12 et E est un élément ou un mélange d'éléments choisis dans le groupe 14, ledit procédé comprenant :
• une première étape de dépôt électrochimique d'une couche mince d'un mélange d'oxydes et/ou d'hydroxydes comprenant pour une couche de type A-B-C₂ au moins un élément du groupe 11 et un élément du groupe 13 ou pour une couche de type A₂-(Dₓ,E₁₋ₓ)-C₄ au moins un élément du groupe 11, au moins un élément du groupe 12 si x>0, et au moins un élément du groupe 14 si x<1,
• une seconde étape de recuit sous atmosphère réductrice de la couche mince,
• une troisième étape d'apport d'au moins un élément du groupe 16 de manière à former une couche mince de type A-B-C₂ ou A₂-(Dₓ,E₁₋ₓ)-C₄ avec 0≤x≤1.

2. Procédé selon la revendication 1, dans lequel le dépôt électrochimique est réalisé à une température supérieure ou égale à 5°C et inférieure ou égale à 95°C.

3. Procédé selon l'une des revendications 1 ou 2, dans lequel le recuit sous atmosphère réductrice est réalisé à une température supérieure ou égale à 300°C et inférieure ou égale à 650°C.

4. Procédé selon l'une quelconques des revendications précédentes, dans lequel le recuit sous atmosphère réductrice a une durée supérieure ou égale à 20 secondes et inférieure ou égale à 15 minutes.

5. Procédé selon l'une quelconques des revendications précédentes, dans lequel préalablement au dépôt électrochimique de la couche mince on prépare une solution aqueuse contenant un mélange de sels de A et de B pour une couche de type A-B-C₂ ou un mélange de sel de A, D et/ou E pour une couche de type A₂-(Dx_{,}E₁₋ₓ)-C₄, en présence d'au moins une espèce donneuse d'oxygène.

6. Procédé selon la revendication 5, dans lequel l'espèce donneuse d'oxygène est constituée par un ion nitrate, ou du dioxygène, ou du peroxyde d'hydrogène ou des ions hypochlorites.

7. Procédé selon l'une quelconques des revendications précédentes, dans lequel A est du cuivre ou de l'argent ou un mélange de cuivre et d'argent et C est du sélénium ou du soufre ou un mélange de sélénium et de soufre.

8. Procédé selon l'une quelconques des revendications précédentes, dans lequel la couche mince d'absorbeur pour cellules photovoltaïques est de type A-B-C₂ et B comprenant un ou plusieurs éléments choisis parmi l'indium, le gallium, l'aluminium ou l'un de leurs mélanges.

9. Procédé selon la revendication 8, dans lequel le dépôt électrochimique est réalisé en imposant une densité de courant entre 1 et 30 mA cm⁻² ou un potentiel supérieur ou égal à -1,8 V et inférieur ou égal à -0,5 V à une électrode comprenant un substrat isolant recouvert d'une couche de molybdène et une électrode de référence Hg/Hg₂SO₄/K₂SO₄ saturée.

10. Procédé selon l'une des revendications 8 ou 9, dans lequel le rapport atomique des éléments A et B dans la solution d'électrolyte est supérieur ou égal à 0,2 et inférieur ou égal à 1,5.

11. Procédé selon l'une quelconques des revendications précédentes, dans lequel la couche mince d'absorbeur pour cellules photovoltaïques est de type A-B-C₂ et B comprenant un mélange d'indium et de gallium, et dans lequel le rapport des concentrations en indium et en gallium dans la solution d'électrolyte est supérieur ou égal à 0,2 et inférieur ou égal à 1,5.

12. Procédé de fabrication d'une cellule solaire, **caractérisé en ce qu'**il comporte un procédé de préparation d'une couche mince d'absorbeur pour cellules photovoltaïques selon l'une des revendications précédentes.

## Patentansprüche

1. Verfahren zur Vorbereitung einer dünnen Absorptionsschicht für photovoltaische Zellen des Typs A-B-C₂ oder A₂-(Dₓ, E₁₋ₓ)-C₄ mit 0≤x≤1, wobei A ein Element oder ein Gemisch von Elementen ist, die in der Gruppe 11 ausgewählt werden, wobei B ein Element oder ein Gemisch von Elementen ist, die in der Gruppe 13 ausgewählt werden, wobei C ein Element oder ein Gemisch von Elementen ist, die in der Gruppe 16 ausgewählt werden, wobei D ein Element oder ein Gemisch von Elementen ist, die in der Gruppe 12 ausgewählt werden, und wobei E ein Element oder ein Gemisch von Elementen ist, die in der Gruppe 14 ausgewählt werden, wobei das Verfahren umfasst:
- einen ersten Schritt des elektrochemischen Aufbringens einer dünnen Schicht eines Gemisches aus Oxiden und/oder Hydroxiden, umfassend für eine Schicht des Typs A-B-C₂ mindestens ein Element der Gruppe 11 und ein Element der Gruppe 13 oder für eine Schicht des Typs A₂-(Dₓ, E₁₋ₓ)-C₄ mindestens ein Element der Gruppe 11, mindestens ein Element der Gruppe 12, wenn x>0, und mindestens ein Element der Gruppe 14, wenn x<1,
- einen zweiten Schritt des Ausglühens der dünnen Schicht unter reduzierender Atmosphäre,
- einen dritten Schritt der Hinzufügung mindestens eines Elements der Gruppe 16, um eine dünne Schicht des Typs A-B-C₂ oder A₂-(Dₓ, E₁₋ₓ) -C₄ mit 0≤x≤1 zu bilden.

2. Verfahren nach Anspruch 1, bei dem das elektrochemische Aufbringen bei einer Temperatur größer oder gleich 5°C und kleiner oder gleich 95°C erfolgt.

3. Verfahren nach einem der Ansprüche 1 oder 2, bei dem das Ausglühen unter reduzierender Atmosphäre bei einer Temperatur größer oder gleich 300°C und kleiner oder gleich 650°C erfolgt.

4. Verfahren nach einem der vorhergehenden Ansprüche, bei dem das Ausglühen unter reduzierender Atmosphäre eine Dauer größer oder gleich 20 Sekunden und kleiner oder gleich 15 Minuten hat.

5. Verfahren nach einem der vorhergehenden Ansprüche, bei dem vor dem elektrochemischen Aufbringen der dünnen Schicht eine wässerige Lösung vorbereitet wird, die ein Gemisch von Salzen von A und B für eine Schicht des Typs A-B-C₂ oder ein Gemisch von Salzen von A, D und/oder E für eine Schicht des Typs A₂-(Dₓ, E₁₋ₓ)-C₄ bei Vorhandensein mindestens einer Sauerstoff spendenden Gattung enthält.

6. Verfahren nach Anspruch 5, bei dem die Sauerstoff spendende Gattung von einem Nitration oder Disauerstoff oder Wasserstoffperoxid oder Hypochloritionen gebildet ist.

7. Verfahren nach einem der vorhergehenden Ansprüche, bei dem A Kupfer oder Silber oder ein Gemisch aus Kupfer und Silber und C Selen oder Schwefel oder ein Gemisch aus Selen und Schwefel ist.

8. Verfahren nach einem der vorhergehenden Ansprüche, bei dem die dünne Absorptionsschicht für photovoltaische Zellen vom Typ A-B-C₂ ist und wobei B ein oder mehrere Elemente umfasst, die unter Indium, Gallium, Aluminium oder einem ihrer Gemische ausgewählt sind.

9. Verfahren nach Anspruch 8, bei dem das elektrochemische Aufbringen erfolgt, indem eine Stromdichte zwischen 1 und 30 mA cm⁻² oder ein Potential größer oder gleich -1,8 V und kleiner oder gleich -0,5 V an eine Elektrode angelegt wird, umfassend ein mit einer Molybdänschicht überzogenes Isoliersubstrat und eine gesättigte Referenzelektrode Hg/Hg₂SO₄/K₂SO₄.

10. Verfahren nach einem der Ansprüche 8 oder 9, bei dem das Atomverhältnis der Elemente A und B in der Elektrolytlösung größer oder gleich 0,2 und kleiner oder gleich 1,5 ist.

11. Verfahren nach einem der vorhergehenden Ansprüche, bei dem die dünne Absorptionsschicht für photovoltaische Zellen vom Typ A-B-C₂ ist und wobei B ein Gemisch aus Indium und Gallium umfasst und bei dem das Konzentrationsverhältnis von Indium und Gallium in der Elektrolytlösung größer oder gleich 0,2 und kleiner oder gleich 1,5 ist.

12. Verfahren zur Herstellung einer Solarzelle, **dadurch gekennzeichnet, dass** es ein Verfahren zur Vorbereitung einer dünnen Absorptionsschicht für photovoltaische Zellen nach einem der vorhergehenden Ansprüche umfasst.

## Claims

1. A method for preparing an A-B-C₂ or A₂-(Dₓ,E₁₋ₓ)-C₄ absorber thin film for photovoltaic cells where 0≤x≤1, A is an element or a mixture of elements selected from group 11, B is an element or a mixture of elements selected from group 13, C is an element or a mixture of elements selected from group 16, D is an element or a mixture of elements selected from group 12 and E is an element or a mixture of elements selected from group 14, said method comprising:
• a first step of electrodepositing a thin film of a mixture of oxides and/or hydroxides comprising, for an A-B-C₂ film, at least one element from group 11 and one element from group 13 or, for an A₂-(Dₓ,E₁₋ₓ)-C₄ film, at least one element from group 11, at least one element from group 12 if x>0, and at least one element from group 14 if x<1,
• a second step of annealing the thin film in a reducing atmosphere,
• a third step of supplying at least one element from group 16 in order to form an A-B-C₂ or A₂-(Dₓ,E₁₋ₓ)-C₄ thin film where 0≤x≤1.

2. The method as claimed in claim 1, wherein the electrodeposition is carried out at a temperature equal to or higher than 5°C and lower than or equal to 95°C.

3. The method as claimed in either of claims 1 and 2, wherein the annealing in reducing atmosphere is carried out at a temperature equal to or higher than 300°C and lower than or equal to 650°C.

4. The method as claimed in any one of the preceding claims, wherein the annealing in reducing atmosphere has a duration of at least 20 seconds and lower than or equal to 15 minutes.

5. The method as claimed in any one of the preceding claims, wherein, prior to the electrodeposition of the thin film, an aqueous solution is prepared containing a mixture of salts of A and B for an A-B-C₂ film or a mixture of salt of A, D and/or E for an A₂-(Dₓ,E₁₋ₓ)-C₄ film, in the presence of at least one oxygen donor species.

6. The method as claimed in claim 5, wherein the oxygen donor species consists of a nitrate ion, or of dioxygen, or of hydrogen peroxide or of hypochlorite ions.

7. The method as claimed in any one of the preceding claims, wherein A is copper or silver or a mixture of copper and silver and C is selenium or sulfur or a mixture of selenium and sulfur.

8. The method as claimed in any one of the preceding claims, wherein the absorber thin film for photovoltaic cells is the A-B-C₂ type and B comprises one or more elements selected from indium, gallium, aluminum or mixtures thereof.

9. The method as claimed in claim 8, wherein the electrodeposition is carried by imposing a current density of between 1 and 30 mA.cm⁻² or a voltage of at least -1.8 V and lower than or equal to -0.5 V to an electrode comprising an insulating substrate coated with a film of molybdenum and a saturated Hg/Hg₂SO₄/K₂SO₄ reference electrode.

10. The method as claimed in either of claims 8 or 9, wherein the atomic ratio of the elements A and B in the electrolyte solution is higher than or equal to 0.2 and lower than or equal to 1.5.

11. The method as claimed in any one of the preceding claims, wherein the absorber thin film for photovoltaic cells is the A-B-C₂ type and B comprises a mixture of indium and gallium, and wherein the ratio of the indium and gallium concentrations in the electrolyte solution is at least 0.2 and lower than or equal to 1.5.

12. A method for manufacturing a solar cell, **characterized in that** it comprises a method for preparing an absorber thin film for photovoltaic cells as claimed in one of the preceding claims.
